(19) **Europäisches Patentamt / European Patent Office / Office européen des brevets**

(11) **EP 3 307 921 B1**

(12) **FASCICULE DE BREVET EUROPEEN**

(45) Date de publication et mention
de la délivrance du brevet:
**19.03.2025   Bulletin 2025/12**

(21) Numéro de dépôt: **16806952.4**

(22) Date de dépôt: **09.06.2016**

(51) Classification Internationale des Brevets (IPC):
$C22C\ 38/38^{(2006.01)}$   $C22C\ 38/32^{(2006.01)}$
$C22C\ 38/28^{(2006.01)}$   $C22C\ 38/26^{(2006.01)}$
$C22C\ 38/22^{(2006.01)}$   $C22C\ 38/18^{(2006.01)}$
$C22C\ 38/14^{(2006.01)}$   $C22C\ 38/12^{(2006.01)}$
$C22C\ 38/06^{(2006.01)}$   $C22C\ 38/04^{(2006.01)}$
$C23C\ 14/06^{(2006.01)}$   $C23C\ 14/02^{(2006.01)}$
$C21D\ 9/48^{(2006.01)}$   $C21D\ 9/46^{(2006.01)}$
$C21D\ 8/02^{(2006.01)}$   $C21D\ 8/04^{(2006.01)}$
$C23C\ 2/02^{(2006.01)}$   $C23C\ 2/06^{(2006.01)}$
$C23C\ 2/28^{(2006.01)}$   $C23C\ 2/40^{(2006.01)}$

(52) Classification Coopérative des Brevets (CPC):
**C21D 8/0226; B32B 15/013; C21D 8/0236;
C21D 8/0247; C21D 8/0273; C21D 8/0426;
C21D 8/0436; C21D 8/0447; C21D 8/0473;
C22C 38/001; C22C 38/002; C22C 38/02;
C22C 38/06; C22C 38/22; C22C 38/26;**   (Cont.)

(86) Numéro de dépôt international:
**PCT/IB2016/000780**

(87) Numéro de publication internationale:
**WO 2016/198940 (15.12.2016 Gazette 2016/50)**

(54) **ACIER À HAUTE RÉSISTANCE ET PROCÉDÉ DE FABRICATION**

HOCHFESTER STAHL UND HERSTELLUNGSVERFAHREN

HIGH-STRENGTH STEEL AND PRODUCTION METHOD

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats de validation désignés:
**MA**

(30) Priorité:   **10.06.2015   PCT/IB2015/000891**

(43) Date de publication de la demande:
**18.04.2018   Bulletin 2018/16**

(73) Titulaire: **Arcelormittal
1160 Luxembourg (LU)**

(72) Inventeurs:
• **DRILLET, Josee
57160 Rozerieul (FR)**
• **HEBERT, Veronique
57070 Saint Julien Metz (FR)**

(74) Mandataire: **Lavoix
2, place d'Estienne d'Orves
75441 Paris Cedex 09 (FR)**

(56) Documents cités:
**EP-A1- 2 123 786     EP-A1- 2 426 230
EP-A1- 2 578 718**

**(Cont. page suivante)**

(52) Classification Coopérative des Brevets (CPC):
(Cont.)**C22C 38/28; C22C 38/32; C22C 38/38;
C23C 2/02; C23C 2/0224; C23C 2/024; C23C 2/06;
C23C 2/28; C23C 2/40; C23C 14/02;** C21D 9/46;
C21D 9/48; C21D 2211/002; C21D 2211/005;
C21D 2211/008

**Description**

La présente invention concerne une tôle d'acier laminée à froid et recuite présentant une très haute résistance mécanique et une aptitude à la déformation pour la fabrication de pièces par mise en forme, en particulier dans l'industrie automobile, pour la fabrication d'éléments de structure de caisse d'automobile, et la fabrication d'une telle tôle.

On a développé des aciers ayant un rapport limite d'élasticité/résistance très favorable lors des opérations de formage.

Leur capacité de consolidation est très grande, ce qui permet une bonne répartition des déformations dans le cas d'une collision et l'obtention d'une limite d'élasticité nettement plus importante sur pièce après formage. On peut réaliser ainsi des pièces aussi complexes qu'avec des aciers conventionnels, mais avec des propriétés mécaniques plus élevées, ce qui autorise une diminution d'épaisseur pour tenir un cahier des charges fonctionnel identique. De la sorte, ces aciers sont une réponse efficace aux exigences d'allègement et de sécurité des véhicules.

Notamment, des aciers dont la structure comprend de la martensite, éventuellement de la bainite, au sein d'une matrice ferritique, ont connu un grand développement car ils allient une résistance élevée à des possibilités importantes de déformation.

Les exigences récentes d'allègement et de réduction de la consommation d'énergie ont conduit à une demande accrue d'aciers à très haute résistance, dont la résistance mécanique Rm est supérieure à 1180 MPa.

Outre ce niveau de résistance, ces aciers doivent présenter une bonne ductilité, une bonne soudabilité et une bonne aptitude au revêtement, notamment une bonne aptitude à la galvanisation en continu au trempé.

Ces aciers doivent également présenter une limite d'élasticité et un allongement à la rupture élevés ainsi qu'une bonne aptitude à la mise en forme.

En effet, certaines pièces automobiles sont fabriquées par des opérations de mise en forme combinant différents modes de déformation. Certaines caractéristiques microstructurales de l'acier peuvent se révéler bien adaptées à un mode de déformation, mais peu favorables vis-à-vis d'un autre mode. Certaines parties des pièces doivent présenter une haute résistance à l'allongement et/ou une bonne aptitude au pliage et/ou une bonne aptitude à la mise en forme d'un bord découpé, notamment lors d'une mise en forme avec bords repoussés.

Cette aptitude à la mise en forme d'un bord découpé est évaluée par détermination d'un rapport d'expansion de trou, noté Ac%. Ce rapport mesure l'aptitude de l'acier à subir une expansion lors d'un emboutissage à froid et fournit donc une évaluation de l'aptitude à la mise en forme dans ce mode de déformation.

Le rapport d'expansion de trou peut être évalué de la façon suivante : après réalisation d'un trou par découpe dans une tôle, on utilise un outil tronconique de façon à réaliser une expansion au niveau des bords de ce trou. C'est au cours de cette opération que l'on peut observer un endommagement précoce au voisinage des bords du trou lors de l'expansion, cet endommagement s'amorçant sur des particules de seconde phase ou aux interfaces entre les différents constituants microstructuraux dans l'acier.

D'après les documents US 2012/0312433 A1 et US 2012/132327 A1, on connaît des aciers dont la résistance mécanique Rm est supérieure à 1180 MPa. Néanmoins, cette résistance mécanique est obtenue au détriment de l'aptitude à la mise en forme et de la soudabilité.

Par ailleurs, d'après les documents US 2013/0209833 A1, US 2011/0048589 A1, US 2011/01683000 A1 et WO 2013/144376 A1, on connaît des aciers ayant une résistance mécanique élevée pouvant dépasser 1000 MPa, mais ne présentant pas simultanément une aptitude à la mise en forme et une soudabilité satisfaisants.

EP2426230 est une document qui avez tôle d'acier galvanisé à haute résistance présentant d'excellentes propriétés de formage, de soudage et de résistance à la fatigue, avec une composition consistant en C : 0,05 % à <0,12 %, Si : 0,35 % à <0,80 %, Mn : 2,0 à 3,5 %, P : 0,001 à 0,040 %, S : 0,0001 à 0,0050 %, Al : 0,005 à 0,1 %, N : 0,0001 à 0,0060 %, Cr : 0, 01 % à 0,5 %, Ti : 0,10 à 0, 080 %, Nb : 0,010 à 0,080 %, B : 0,0001 à 0,0030 %, facultativement Mo : 0,01 à 0,15 %, Ca : 0,0001 à 0,0050 %, terres rares : 0,0001 à 0,1 %, Sb : 0,0001 à 0,1 %, et éventuellement V : inférieur à 0,05 %, Zr : inférieur à 0,0200 %, Mg : inférieur à 0,0200 %, Cu : inférieur à 0,4 %, et Ni : inférieur à 0,4 %, toujours en pourcentage massique, le reste étant constitué de Fe et des impuretés inévitables ; une microstructure consistant en 20 % à 70 % en volume d'une phase ferrite avec un diamètre de grain moyen inférieur ou égal à 5 mm, 30 % à 80 % en volume de bainite et/ou de martensite avec un diamètre de grain moyen inférieur ou égal à 5 mm ; des teneurs d'austénite résiduelle et de perlite inférieures ou égales à 5 % en volume et une résistance à la traction supérieure ou égale à 980 MPa ; et une couche galvanisée sur une surface de la tôle avec un poids de revêtement (par côté) de 20 g/m2 à 150 g/m2.

Par ailleurs, EP2578718 est une document qui avez tôle d'acier galvanisée de haute résistance ayant une excellente aptitude au pliage et au soudage, constituée, dans laquelle une couche de surface de la tôle d'acier, qui constitue une partie de la tôle d'acier jusqu'à une profondeur de 10 mm mesurée à partir de chaque surface de la tôle d'acier, a une structure contenant plus de 70 % de phase ferrite en fraction volumique, une partie de couche interne de la tôle d'acier, sur le côté plus à intérieur que la profondeur de 10 mm mesurée à partir de chaque surface, a une structure constituée de 20 à 70 % en fraction volumique de phase ferrite avec une taille moyenne de grain cristallin inférieure ou égale à 5 mm ; 30 à 80 % de phase bainite et/ou de phase martensite en fraction volumique, avec une taille moyenne de grain cristallin inférieure ou égale à 5 mm ; et une phase austénite résiduelle et/ou une phase perlite inférieure ou égale à 5 % (0 % inclus) en fraction volumique comme reste, la tôle d'acier a une résistance à la traction supérieure ou égale à 980 MPa et la tôle d'acier a une couche galvanisée sur l'une de ses surfaces.

Par ailleurs, EP2123786 est une invention concerne une tôle d'acier Dual Phase laminée à froid et recuite de résistance comprise entre 980 et 1100MPa, d'allongement à rupture supérieur à 9 %, dont la composition comprend, les teneurs étant exprimées en poids : $0,055 \leq C \leq 0,095\%$, $2\% \leq Mn \leq 2,6\%$, $0,005 \leq Si \leq 0,35\%$, $S \leq 0,005\%$, $P \leq 0,050\%$, $0,1 \leq Al \leq 0,3\%$, $0,05\%:5Mo \leq 0,25\%$, $0,2\% \leq Cr \leq 0,5\%$, étant entendu que $Cr+2Mo \leq 0,6\%$, $Ni \leq 0,1\%$, $0,010 \leq Nb \leq 0,040\%$, $0,010 \leq Ti \leq 0.050\%$, $0,0005 \leq B \leq 0,0025\%$, $0,002\% \leq N \leq 0,007\%$, le reste de la composition étant constitué de fer et d'impuretés inévitables résultant de l'élaboration.

Dans ces conditions, un but de l'invention consiste à mettre à disposition une tôle d'acier présentant une résistance mécanique élevée, notamment comprise entre 1180 et 1320 MPa, conjointement avec une limite d'élasticité élevée, notamment comprise entre 750 et 970 MPa, cette valeur étant déterminée avant toute opération de skin-pass sur la tôle, une bonne aptitude à la mise en forme, notamment un rapport d'expansion de trou Ac% supérieur ou égal à 20%, un angle de pliage, pour une tôle d'épaisseur comprise entre 0,7 mm et 2mm, supérieur ou égal à 40°, et un allongement à rupture supérieur à 7%.

A cet effet, l'invention a pour objet une tôle d'acier laminée à froid et recuite d'épaisseur comprise entre 0,7 mm et 2mm, de résistance mécanique comprise entre 1180 MPa et 1320 MPa, dont le rapport d'expansion de trou Ac% est supérieur à 20% et l'angle de pliage supérieur ou égal à 40°, dont la composition chimique comprend, les teneurs étant exprimées en poids : $0,09 \leq C \leq 0,11\%$, $2,6 \leq Mn \leq 2,8\%$, $0,20 \leq Si \leq 0,55\%$, $0,25 \leq Cr < 0,5\%$, $0,025 \leq Ti \leq 0,040\%$, $0,0015 \leq B \leq 0,0025\%$, $0,005 \leq Al \leq 0,18\%$, $0,08 \leq Mo \leq 0,15\%$, $0,020 \leq Nb \leq 0,040\%$, $0,002 \leq N \leq 0,007\%$, $0,0005\% \leq S \leq 0,005\%$, $0,001\% < P < 0,020\%$, $Ca < 0,003\%$, le reste étant constitué de fer et d'impuretés inévitables provenant de l'élaboration, la tôle ayant une microstructure constituée de martensite et/ou de bainite inférieure, ladite martensite comprenant de la martensite fraîche et/ou de la martensite auto-revenue, la somme des proportions surfaciques de martensite et de bainite inférieure étant comprise entre 40 à 70%, de 15 à 45% en proportion surfacique de bainite à faible quantité de carbures, de 5 à moins de 20% en proportion surfacique de ferrite, la fraction de ferrite non recristallisée par rapport à la fraction de ferrite totale, étant inférieure à 15%, et de moins de 5% en proportion surfacique d'austénite résiduelle sous forme d'îlots, la fraction des anciens grains austénitiques dont la taille est inférieure à moins de un micromètre représentant de 40 à 60% de la population totale desdits anciens grains austénitiques.

Dans des modes de réalisation, la tôle suivant l'invention comporte en outre une ou plusieurs des caractéristiques suivantes :

- la microstructure comprend, en proportion surfacique, de 15 à 45% de martensite fraîche.
- la microstructure comprend, en proportion surfacique, de 5 à 50% de somme de martensite auto-revenue et de bainite inférieure.
- la martensite auto-revenue et ladite bainite inférieure contiennent des carbures sous forme de bâtonnets orientés dans les directions <111> des lattes martensitiques et bainitiques.
- la bainite à faible quantité de carbures contient moins de 100 carbures par unité de surface de 100 micromètres carrés.
- la tôle d'acier contient des précipités du type $(Ti, Nb, Mo)(C,N)$ de taille inférieure à 5 nanomètres, présents en quantité inférieure à 10 000 précipités/$\mu m^3$
- la composition chimique comprend, la teneur étant exprimée en poids : $2,6 \leq Mn \leq 2,7\%$.
- la composition chimique comprend préférentiellement, la teneur étant exprimée en poids : $0,30 \leq Si \leq 0,5\%$.
- selon un mode préférentiel, la composition chimique comprend, la teneur étant exprimée en poids : $0,005 \leq Al \leq 0,030\%$.
- la tôle peut comporter un revêtement de zinc ou d'alliage de zinc, obtenu au trempé.
- le revêtement de zinc ou d'alliage de zinc peut être un revêtement galvanisé-allié, le revêtement de zinc ou d'alliage de zinc comprenant de 7 à 12% en poids de fer.
- la tôle d'acier peut comporter un revêtement de zinc ou d'alliage de zinc, obtenu par dépôt sous vide.

L'invention a également pour objet un procédé de fabrication d'une tôle laminée à froid et recuite, revêtue de zinc ou d'un alliage de zinc, selon l'une quelconque des caractéristiques ci-dessus, comprenant les étapes successives suivantes :

- on approvisionne un demi-produit dont la composition chimique comprend, les teneurs étant exprimées en poids : $0,09 \leq C \leq 0,11\%$, $2,6 \leq Mn \leq 2,8\%$, $0,20 \leq Si \leq 0,55\%$, $0,25 \leq Cr < 0,5\%$, $0,025 \leq Ti \leq 0,040\%$, $0,0015 \leq B \leq 0,0025\%$, $0,005 \leq Al \leq 0,18\%$, $0,08 \leq Mo \leq 0,15\%$, $0,020 \leq Nb \leq 0,040\%$, $0,002 \leq N \leq 0,007\%$, $0,0005 \leq S \leq 0,005\%$, $0,001 \leq P \leq 0,020\%$, $Ca \leq 0,003\%$, le reste étant constitué de fer et d'impuretés inévitables provenant de l'élaboration, puis

    - on chauffe le demi-produit à une température $T_r$ supérieure ou égale à 1250°C,

- puis on lamine à chaud le demi-produit, la température de fin de laminage étant supérieure à la température Ar3 de début de transformation de l'austénite au refroidissement, pour obtenir une tôle laminée à chaud, puis
- on refroidit la tôle laminée à chaud à une vitesse supérieure à 30°C/s pour éviter la formation de ferrite et de perlite, puis
- on bobine la tôle laminée à chaud à une température comprise entre 580° et 500°C, puis
- on lamine à froid la tôle laminée à chaud pour obtenir une tôle laminée à froid, puis
- on réchauffe la tôle laminée à froid entre 600°C et Ac1, Ac1 désignant la température de début de transformation austénitique au chauffage, avec une vitesse de réchauffage $V_C$ comprise entre 1 et 20°C/s,
- on porte la tôle laminée à froid jusqu'à une température Tm comprise entre 780°C et (Ac3-25°C), et on maintient à la température Tm la tôle laminée à froid pendant une durée Dm comprise entre 30 et 150 secondes, étant entendu que Ac3 désigne la température de fin de transformation austénitique au chauffage, puis
- on refroidit la tôle à une vitesse VR1 comprise entre 10 et 150°C/s jusqu'à une température Te comprise entre 400 et 490°C, puis
- on maintient la tôle à la température Te pendant une durée De comprise entre 5 et 150 secondes, puis
- on revêt la tôle par passage en continu en immersion dans un bain de zinc ou en alliage de zinc à une température TZn comprise entre 450°C et 480°C, lesdites températures Te et TZn étant telles que 0°C ≤ (Te-TZn) ≤ 10°C, de façon à obtenir une tôle revêtue, puis
- on réchauffe optionnellement la tôle revêtue à une température $T_G$ comprise entre 490°C et 550°C pendant une durée $t_G$ comprise entre 10 s et 40 s.

D'autres caractéristiques et avantages de l'invention apparaîtront au cours de la description ci-dessous, donnée à titre d'exemple et faite en référence aux figures annexées ci-jointes parmi lesquelles :

- la Figure 1 présente la microstructure d'une tôle d'acier selon l'invention, mise en évidence par un premier type d'attaque métallographique.
- la Figure 2 présente la microstructure de la tôle d'acier de la Figure 1, mise en évidence par un deuxième type d'attaque métallographique.
- La figure 3 présente un exemple de précipitation de carbonitrures de (Ti , Nb, Mo)(C, N) dans une tôle selon l'invention, observée en microscopie électronique à transmission.
- La figure 4 présente un exemple de précipitation de carbonitrures de (Ti , Nb, Mo)(C,N) ne correspondant pas à l'invention, observée en microscopie électronique à transmission.

On désignera par ailleurs par Ac1 la température de début de transformation allotropique au chauffage de l'acier.
On désignera par Ac3 la température de fin de transformation austénitique au chauffage.
On désignera par Ar3 la température de début de transformation de l'austénite au refroidissement.
On désignera par Ms la température de début de transformation martensitique.
La microstructure de la tôle selon l'invention comprend de la martensite. Celle-ci est issue d'une transformation sans diffusion de l'austénite γ en dessous de la température de début de transformation martensitique Ms au refroidissement.
La martensite se présente sous la forme de fines lattes allongées dans une direction, et orientées à l'intérieur de chaque grain initial d'austénite. Sous le terme martensite, on inclut à la fois la martensite fraîche et la martensite auto-revenue. On distinguera par la suite la martensite auto-revenue de la martensite fraîche, c'est-à-dire non revenue et non auto-revenue.
Notamment, la martensite auto-revenue se présente sous la forme de fines lattes comprenant des carbures de fer dispersés dans ces lattes, sous forme de bâtonnets orientés selon les directions <111> de la maille α' des lattes. Cette martensite auto-revenue est formée par précipitation des carbures de fer en-dessous de la température de transformation martensitique Ms lorsque le refroidissement n'est pas suffisamment lent pour produire de la martensite fraîche. Au contraire, la martensite fraîche ne comprend pas de carbures.
La bainite, formée lors d'un refroidissement depuis le domaine austénitique, au-dessus de la température de début de transformation martensitique Ms, se présente sous la forme d'un agrégat de lattes de ferrite et de particules de cémentite. Sa formation fait intervenir une diffusion à courte distance.
On distinguera par la suite la bainite inférieure de la bainite à faible quantité de carbures. La bainite inférieure est formée, lors du refroidissement, dans une gamme de températures immédiatement au dessus de la température de transformation martensitique Ms. Elle se présente sous forme de fines lattes et comprend des carbures dispersés dans ces lattes.
Par ailleurs, on appellera bainite à faible quantité de carbures, de la bainite contenant moins de 100 carbures par unité de surface de 100 micromètres carrés. La bainite à faible quantité de carbures est formée, lors du refroidissement, entre 550°C et 450°C. Au contraire de la bainite à faible quantité de carbures, la bainite inférieure contient toujours plus de 100 carbures par unité de surface de 100 micromètres carrés.

Dans la composition chimique de l'acier de l'invention, le carbone joue un rôle sur la formation de la microstructure et sur les propriétés mécaniques.

La teneur en poids en carbone est comprise entre 0,09% et 0,11 %. Cette gamme de teneur en carbone contribue à obtenir simultanément une résistance mécanique supérieure à 1180 MPa, un allongement à la rupture supérieur à 7%, et un rapport d'expansion de trou Ac% satisfaisant, supérieur ou égal à 20%. Notamment, une teneur en carbone inférieure à 0,09% ne permet pas d'atteindre une résistance mécanique suffisante. Pour une teneur en carbone plus élevée, supérieure à 0,11%, l'aptitude au soudage tend à diminuer et la température Ms est abaissée, de telle sorte que la fraction de martensite fraîche dans la microstructure, tend à augmenter et ainsi à dégrader le rapport d'expansion de trou.

La teneur en poids en manganèse est comprise entre 2,6% et 2,8%. Le manganèse est un élément gammagène qui abaisse la température Ac3 et la température Ms de début de formation de la martensite. La faible teneur en carbone de l'acier pourrait conduire à une température Ac3 élevée, supérieure à 860°C. Une teneur en manganèse supérieure à 2,6% permet, en abaissant la valeur de la température Ac3, d'obtenir une austénisation complète de l'acier entre 840°C et 855°C environ, après un maintien à cette température pendant une durée d'au moins 30s. Le manganèse permet par ailleurs la formation de martensite auto-revenue et contribue donc à obtenir un rapport d'expansion de trou Ac% supérieur ou égal à 20%. La teneur en poids en manganèse est limitée à 2,8% afin de limiter la formation de structures en bandes, et préférentiellement comprise entre 2,6 et 2,7%.

Le silicium est un élément participant au durcissement en solution solide, dont la teneur en poids dans l'acier est comprise entre 0,20% et 0,55% en poids, de préférence entre 0,30% et 0,5%. Une teneur d'au moins 0,30% permet d'obtenir un durcissement suffisant de la ferrite et/ou de la bainite. La teneur en poids en silicium est limitée à 0,55% pour garantir un rapport d'expansion de trou Ac% supérieur ou égal à 20%, en limitant la formation de bainite supérieure. En outre, une augmentation de la teneur en silicium dégrade l'aptitude au revêtement de l'acier en favorisant la formation d'oxydes adhérents à la surface de la tôle. Une teneur en silicium inférieure à 0,55% contribue également à assurer une bonne aptitude au soudage.

Le silicium est un élément alphagène et contribue à élever la température Ac3 et à favoriser la formation de bainite à faible quantité de carbures. Une teneur en silicium inférieure à 0,55% contribue ainsi à éviter la formation d'une quantité trop importante de bainite à faible quantité de carbures.

La composition de la tôle en acier comporte par ailleurs du chrome en quantité supérieure ou égale à 0,25 % en poids, de façon à améliorer la trempabilité de l'acier, et à augmenter sa dureté ainsi que sa résistance mécanique. La teneur en chrome doit être inférieure à 0,5%, de façon à conserver un allongement à la rupture satisfaisant et à limiter les coûts de fabrication.

Le titane est présent dans l'acier en quantité comprise entre 0,025% et 0,040% en poids. En quantité comprise entre 0,025 et 0,040%, le titane se combine notamment à l'azote et au carbone pour précipiter sous forme de nitrures et/ou de carbonitrures. En deçà de 0,025%, il existe un risque que la résistance mécanique de 1180 MPa ne soit pas atteinte.

Au-delà d'une teneur en titane de 0,040%, il existe un risque de former des nitrures de titane grossiers précipités dès l'état liquide, qui tendent à réduire la ductilité, et à conduire à un endommagement précoce lors de l'expansion de trou. En effet, lorsque des nitrures de taille supérieure à 6 micromètres sont présents, on constate que ceux-ci sont majoritairement à l'origine des décohésions avec la matrice lors des étapes de découpe et d'emboutissage. Le titane permet par ailleurs de faire en sorte que l'azote soit entièrement combiné sous forme d'une précipitation durcissante, si bien que le bore se trouve sous forme libre et peut jouer un rôle efficace sur la trempabilité. Le titane est en quantité surstoechiométrique par rapport à l'azote, si bien que le rapport : Ti/N est supérieur à 3,42.

La teneur en poids en bore est comprise entre 0,0015% et 0,0025%. En limitant l'activité du carbone, le bore permet en effet de contrôler et de limiter les transformations de phase diffusives (transformation ferritique ou perlitique lors du refroidissement) et de former des phases durcissantes (bainite ou martensite) nécessaires à l'obtention de hautes caractéristiques de résistance mécanique. L'ajout de bore permet par ailleurs de limiter l'addition d'éléments trempants tels que Mn, Mo, Cr et de réduire le coût analytique de la nuance d'acier. Selon l'invention, la teneur minimale en bore pour assurer une trempabilité efficace est de 0,0015%. Au delà de 0,0025%, l'effet sur la trempabilité est saturé et on constate un effet néfaste sur la revêtabilité et sur la ductilité.

La composition de la tôle en acier comporte également du molybdène, en quantité comprise entre 0,08 et 0,15% en poids. Le molybdène joue, comme le chrome, un rôle efficace sur la trempabilité, en teneur supérieure à 0,08%.

Une teneur supérieure à 0,15% de molybdène retarde la recristallisation de la ferrite. La résistance mécanique Rm est alors trop élevée, supérieure à 1320 MPa, ce qui se traduit conjointement par une baisse de ductilité.

Lorsque la température de recuit est inférieure à (Ac3-25°C), une addition dans les conditions de l'invention permet d'obtenir, en combinaison avec le titane et le niobium, une précipitation nanométrique de carbonitrures de molybdène, titane et Niobium (Ti, Nb, Mo)(C,N) qui contribue au durcissement et permet d'obtenir une résistance Rm supérieure ou égale à 1180 MPa après recuit.

Mais une précipitation trop dense de composés de petite taille conduit à un durcissement excessif : lorsque la densité de précipités de taille inférieure à 5 nanomètres excède 10 000 précipités/$\mu m^3$, la résistance Rm peut excéder 1320 MPa et l'aptitude à la déformation à froid devient insuffisante.

Une addition de molybdène en quantité prévue par l'invention, permet d'obtenir une tôle d'acier moins sensible à des fluctuations éventuelles dans les étapes qui suivent le recuit à la température Tm. En effet, bien que la vitesse de refroidissement VR et la température Te soient contrôlées dans des conditions industrielles de façon continue en fonction de points de consigne définis, une fluctuation légère de ces paramètres peut intervenir parfois de façon transitoire. Il importe que ces fluctuations n'aient pas d'incidence sur les caractéristiques du produit final. Dans la gamme définie par l'invention, des fluctuations modérées de VR ou de Te, par exemple de 7%, conduisent à une variation de résistance mécanique Rm inférieure à 7%.

La composition chimique de la tôle d'acier laminée à chaud comporte du niobium, avec une teneur en poids comprise entre 0,020 et 0,040%. En quantité supérieure à 0,020%, le niobium permet d'obtenir une augmentation de la résistance Rm. Au delà d'une teneur en poids de 0,040%, la recristallisation de l'austénite est retardée. La structure contient alors une fraction significative de grains allongés, ce qui ne permet plus d'atteindre le rapport d'expansion de trou Ac% visé.

En outre, la teneur en poids de l'azote est comprise entre 0,002% et 0,007%. Afin de former une quantité suffisante de nitrures et de carbonitrures, la teneur en azote doit être supérieure à 0,002%. La teneur en azote doit être inférieure à 0,007% dans le but d'éviter une précipitation de nitrures de bore, ce qui diminuerait la quantité de bore libre.

Une teneur en poids en aluminium comprise entre 0,005% et 0,18 % permet d'assurer la désoxydation de l'acier pendant sa fabrication. Une teneur en aluminium doit être inférieure à 0,18%, voire inférieure à 0,030% pour éviter une élévation de la température Ac3 et éviter la formation de ferrite lors du refroidissement.

La teneur en soufre doit être inférieure à 0,005%. Au-delà de cette teneur, la ductilité est réduite en raison de la présence excessive de sulfures tels que MnS qui diminuent l'aptitude à la déformation, en particulier le rapport d'expansion de trou Ac%. L'obtention de teneur en soufre extrêmement réduite, inférieure à 0,0005%, est cependant très coûteuse, sans avantage significatif au regard aux coûts de fabrication. D'un point de vue pratique, une teneur en soufre non inférieure à 0,0005% peut donc être retenue.

La teneur en phosphore doit être inférieure à 0,020%. En effet, le phosphore est un élément qui confère un durcissement par solution solide mais qui diminue la soudabilité par points et la ductilité à chaud, particulièrement en raison de son aptitude à la ségrégation aux joints de grains ou à la co-ségrégation avec le manganèse.

L'obtention de teneur en phosphore extrêmement réduite, inférieure à 0,001%, est cependant très coûteuse, sans avantage significatif au regard aux coûts de fabrication. D'un point de vue pratique, une teneur en phosphore non inférieure à 0,001% peut donc être retenue.

En quantité inférieure à 0,003%, le calcium permet d'éviter la présence d'inclusions allongées, notamment de sulfures, qui influencent défavorablement la ductilité.

Dans la microstructure de la tôle d'acier selon l'invention, la somme des proportions surfaciques de martensite et de bainite inférieure est comprise entre 40 à 70% La microstructure contient également, en proportion surfacique, de 15 à 45% de bainite à faible quantité de carbures, de 5 à moins de 20% de ferrite, et moins de 5% d'austénite résiduelle sous forme d'îlots. La fraction surfacique de ferrite non recristallisée par rapport à la fraction de ferrite totale, est inférieure à 15%, ce qui permet d'obtenir simultanément une résistance Rm compris entre 1180 et 1320 MPa, un allongement supérieur à 7% et un rapport d'expansion de trou supérieur ou égal à 20%.

Comme on l'a indiqué précédemment, on distingue la martensite auto-revenue de la martensite fraîche , c'est-à-dire non revenue et non auto-revenue.

Selon un mode de réalisation, la martensite est formée notamment de martensite auto-revenue, le pourcentage surfacique de la somme de la martensite auto-revenue et de la bainite inférieure représentant au moins 5% de l'ensemble de la microstructure, cette proportion pouvant aller jusqu'à 50%.

La martensite auto-revenue et la bainite inférieure sont présentes sous la forme de fines lattes, et comprennent des carbures dispersés dans ces lattes. En particulier, la martensite auto-revenue et la bainite inférieure comprennent des carbures de fer $Fe_2C$ et $Fe_3C$ sous forme de bâtonnets orientés dans les directions <111> de la maille des lattes martensitiques et bainitiques. Les pourcentages de martensite auto-revenue et de bainite inférieure sont spécifiés conjointement car la martensite auto-revenue et la bainite inférieure ont sensiblement le même rôle sur les propriétés d'usage de l'acier. De plus, ces deux constituants, présents sous forme de fines lattes, ne peuvent être identifiés individuellement l'un de l'autre lors d'observations en microscopie électronique à balayage. Seuls des examens en microscopie électronique à transmission permettent de distinguer ces deux constituants.

Un pourcentage surfacique de la somme de martensite auto-revenue et de bainite inférieure compris entre 40% et 70% permet de favoriser l'aptitude à la mise en forme de l'acier, notamment son aptitude au pliage et son aptitude à la mise en forme d'un bord découpé. Un pourcentage de martensite auto-revenue et de bainite inférieure d'au moins 40% contribue ainsi à obtenir un angle de pliage satisfaisant, notamment un angle de pliage pour des tôles d'épaisseur comprise entre 0,7 mm et 2 mm, d'au moins 40°, et un rapport d'expansion de trou Ac% supérieur ou égal à 20%.

Le pourcentage de la somme de martensite auto-revenue et de bainite inférieure dans la microstructure doit être inférieur à 70% afin de conserver un pourcentage suffisant de bainite à faible quantité de carbures, permettant d'obtenir un allongement à la rupture d'au moins 7%.

La martensite peut par ailleurs comprendre en partie de la martensite fraîche dans un pourcentage surfacique compris entre 15 et 45% de l'ensemble de la microstructure.Le pourcentage surfacique de martensite fraîche doit être inférieur à 45%, en particulier pour ne pas diminuer la ductilité de l'acier et pour assurer un bon rapport d'expansion de trou.

La microstructure comprend en outre, en proportion surfacique, de 15 à 45% de bainite à faible quantité de carbures. Celle-ci est formée lors du refroidissement après le recuit à la température Tm, et lors du maintien entre 550°C et 450°C. Sa formation est favorisée notamment grâce à l'addition de silicium qui tend à retarder la précipitation des carbures, conjointement avec une faible quantité d'éléments trempants tels que le carbone ou le manganèse.

La bainite à faible quantité de carbures permet d'augmenter l'allongement à la rupture. En particulier, un pourcentage surfacique de bainite à faible quantité de carbures d'au moins 15% permet d'obtenir un allongement à la rupture d'au moins 7%. Le pourcentage surfacique de bainite à faible quantité de carbures doit être limité à 45% afin de garantir un rapport d'expansion de trou supérieur ou égal à 20% et une résistance mécanique supérieure ou égale à 1180 MPa.

La microstructure comprend par ailleurs de 5 à moins de 20 % de ferrite en proportion surfacique. Si la teneur en ferrite est inférieure à 5%, il existe un risque d'obtenir conjointement trop de martensite autorevenue associée à une limite d'élasticité trop faible. Si la teneur en ferrite excède 20%, il existe un risque que la résistance Rm soit inférieure à 1320 MPa.

La microstructure peut également contenir jusqu'à 5%, en proportion surfacique, d'austénite résiduelle sous la forme d'îlots, formant notamment des plaquettes entre les lattes de martensite auto-revenue et de bainite inférieure.

Par ailleurs, les inventeurs ont également mis en évidence l'importance du contrôle de la taille des grains austénitiques créés lors du recuit de la tôle laminée à froid, c'est-à-dire existant à haute température à l'issue du maintien de recuit, avant le refroidissement ultérieur. Ces grains austénitiques sont qualifiés « d'anciens grains austénitiques », car ces grains sont remplacés par d'autres constituants lors des transformations allotropiques au refroidissement. Comme on va l'expliquer, la taille de ces anciens grains austénitiques peut néanmoins être mise en évidence par différentes méthodes, sur le produit final. Selon l'invention, la fraction des anciens grains austénitiques dont la taille est inférieure à un micromètre, représente entre 40 et 60% de la population totale de ces anciens grains austénitiques

La fraction des anciens grains austénitiques dont la taille est inférieure à un micromètre est par exemple déterminée au moyen d'un réactif approprié, dont la vitesse d'attaque dépend de certaines ségrégations locales aux anciens joints, tel que par exemple le réactif Béchet-Beaujard, connu en lui-même. A cet effet, un échantillon d'acier à l'état final, c'est-à-dire à l'issue du procédé de fabrication selon l'invention, est attaqué par un réactif approprié, notamment un réactif composé d'une solution aqueuse saturée d'acide picrique additionnée d'au moins 0,5% d'alkylsulfonate de sodium, pendant une durée comprise entre quelques minutes et une heure.

A l'issue de cette attaque, un examen micrographique de l'échantillon permet de visualiser les joints des anciens grains austénitiques, et de réaliser un histogramme de distribution de la taille de ces anciens grains austénitiques, notamment de déterminer la fraction des anciens grains austénitiques dont la taille est inférieure à un micromètre.

Alternativement, la taille des anciens grains austénitiques peut être déterminée au moyen d'une trempe interrompue lors du refroidissement après recuit, en adoptant des conditions de refroidissement initial de façon à provoquer une germination ferritique intergranulaire, puis à interrompre celle-ci par trempe.

Les inventeurs ont mis en évidence que la taille de ces anciens grains d'austénite conditionne la cinétique de transformation de phases lors du refroidissement suivant le recuit. Notamment, les grains austénitiques de faible taille, inférieure à un micromètre, contribuent à abaisser la valeur de la température Ms et ainsi à augmenter la formation de martensite fraîche.

A l'inverse, la présence de gros grains austénitiques diminue la formation de bainite à faible quantité de carbures.

Une fraction d'anciens grains austénitiques dont la taille est inférieure à un micromètre, comprise entre 40 et 60% de la population totale des grains austénitiques contribue à abaisser la température Ms de transformation martensitique, à éviter la formation d'une proportion trop importante de martensite auto-revenue et de bainite inférieure, ce qui diminuerait l'allongement et la limite d'élasticité.

Les caractéristiques microstructurales présentées ci-dessus sont déterminées par exemple en observant la microstructure par Microscopie Electronique à Balayage au moyen d'un canon à effet de champ (technique « MEB-FEG ») à un grandissement supérieur à 1200x, couplé à un détecteur EBSD (« Electron Backscatter Diffraction »). Les morphologies des lattes et des grains sont ensuite déterminées par analyse d'images au moyen de logiciels connus en eux-mêmes, par exemple le logiciel Aphelion®.

La tôle d'acier laminée à froid et recuite selon l'invention peut être produite nue, sans revêtement, mais elle peut également être revêtue. Par exemple, un tel revêtement peut être formé de zinc ou d'alliage de zinc, notamment un revêtement galvanisé-allié comprenant de 7 à 12% en poids de fer.

Notamment, une telle tôle d'acier est bien adaptée au dépôt d'un revêtement métallique, en particulier par galvanisation au trempé selon les procédés usuels. En particulier, la composition et les caractéristiques mécaniques de l'acier sont compatibles avec les contraintes et les cycles thermiques des procédés de revêtement de zinc au trempé en continu.

Le procédé de revêtement utilisé dépend de l'application visée. Notamment, le revêtement peut être obtenu au trempé, par une technique de dépôt sous vide telle que JVD (« Jet Vapour Deposition »), ou bien par électrodéposition cationique.

Les inventeurs ont mis en évidence le fait qu'une tôle d'acier selon l'invention présente une résistance mécanique comprise entre 1180 et 1320 MPa, conjointement avec une limite d'élasticité comprise entre 750 et 970 MPa, avant toute opération de skin-pass, un allongement à la rupture d'au moins 7%, notamment supérieur à 8%, et un rapport d'expansion de trou Ac% supérieur ou égal à 20%.

En particulier, une limite d'élasticité comprise entre 800 et 970 MPa est obtenue tout en conservant une résistance mécanique inférieure à 1320 MPa. En outre, une telle tôle présente un angle de pliage élevé. En particulier, lorsque la tôle a une épaisseur comprise entre 0,7 mm et 2 mm, l'angle de pliage est d'au moins 40°.

La mise en œuvre du procédé de fabrication d'une tôle laminée selon l'invention comporte les étapes successives suivantes :

On approvisionne un acier de composition selon l'invention, et on procède à la coulée d'un demi-produit à partir de cet acier. Cette coulée peut être réalisée en lingots ou en continu sous forme de brames d'épaisseur de l'ordre de 200mm.

Les demi-produits coulés sont tout d'abord portés à une température $T_R$ supérieure à 1250 °C, afin d'homogénéiser l'acier et de dissoudre complètement les précipités.

Puis, on lamine à chaud le demi-produit dans un domaine de température où la structure de l'acier est totalement austénitique, c'est-à-dire à une température $T_{FL}$ supérieure à la température Ar3 de début de transformation de l'austénite au refroidissement. Si la température $T_{FL}$ est inférieure à la température Ar3, les grains de ferrite sont écrouis par le laminage et la ductilité est réduite. Préférentiellement, on choisira une température de fin de laminage supérieure à 875°C.

La tôle laminée à chaud est refroidie à une vitesse supérieure à 30°C/s pour éviter la formation de ferrite et de perlite, puis la tôle laminée à chaud est bobinée à une température $T_{Bob}$ comprise entre 500°C et 580°C. La température de bobinage doit être inférieure à 580°C pour éviter une oxydation lors du bobinage. Une température de bobinage trop basse, c'est-à-dire inférieure à 500°C, conduit à une augmentation de la dureté de l'acier, ce qui augmente les efforts nécessaires lors du laminage à froid ultérieur. La gamme de température de bobinage permet également d'éviter la formation de perlite.

La tôle est ensuite décapée, par un des procédés connus en eux-mêmes.

On effectue ensuite un laminage à froid, avec un taux de réduction par exemple compris entre 40% et 70% de façon à introduire une quantité de déformation permettant une recristallisation ultérieure.

On chauffe ensuite la tôle laminée à froid, préférentiellement au sein d'une installation de recuit continu, avec une vitesse moyenne de chauffage $V_C$ comprise entre 1°C/s et 20°C/s entre 600°C et la température Ac1 (température de début de transformation allotropique en austénite au chauffage).

La température Ac1 peut être mesurée par dilatométrie, ou évaluée au moyen de la formule suivante publiée dans « Darstellung der Umwandlungen für technische Anwendungen und Möglichkeiten ihrer Beeinflussung », H.P. Hougardy, Werkstoffkunde Stahl Band 1,198-231, Verlag Stahleisen, Düsseldorf, 1984 :

$$Ac1 = 739 - 22*C - 7*Mn + 2*Si + 14*Cr + 13*Mo - 13*Ni.$$

Dans cette formule, la température Ac1 est exprimée en degrés Celsius, et les teneurs élémentaires de la composition sont exprimées en pourcentages en poids.

Lors du chauffage de l'acier entre 600°C et Ac1, il se produit un début de recristallisation et il se forme des précipités de (TiNbMo)(CN), qui permettent de contrôler la distribution de la taille des grains austénitiques formés à partir de Ac1. D'une manière surprenante, les inventeurs ont mis en évidence le fait que le contrôle de la vitesse moyenne de chauffage $V_C$ entre 600°C et Ac1 et ainsi du temps de chauffage entre 600°C et Ac1, qui correspond au temps entre le début de recristallisation et le début de la transformation de phases, est déterminant pour les cinétiques des transformations de phases ultérieures, notamment lors de l'étape de maintien ultérieure à la température de recuit Tm. Les inventeurs ont ainsi mis en évidence, de manière inattendue, que le choix d'une vitesse moyenne de chauffage $V_C$ entre 600°C et Ac1 comprise entre 1°C/s et 20°C/s permet, à l'issue du procédé de fabrication, d'obtenir un acier dont la microstructure est constituée, en proportion surfacique, de 40 à 70% en somme de martensite et de bainite inférieure, de 15 à 45% de bainite à faible quantité de carbures, de 5 à moins de 20 % de ferrite, et de moins de 5% d'austénite résiduelle sous forme d'îlots.

Notamment, une vitesse moyenne de chauffage $V_C$ inférieure à 1°C/s conduirait à une durée trop longue du chauffage entre 600°C et Ac1, donc à une formation trop importante de ferrite et à une résistance mécanique trop faible.

Au contraire, une vitesse moyenne de chauffage $V_C$ supérieure à 20°C/s conduirait à un temps de chauffe entre 600°C et Ac1 trop faible, et à une croissance insuffisante des grains ferritiques lors du chauffage entre 600°C et Ac1.

Or, les inventeurs ont mis en évidence que la taille des grains ferritiques obtenus à l'issue du chauffage entre 600°C et Ac1 a une influence sur la taille des grains d'austénite à l'issue de l'austénisation. Une croissance insuffisante des grains ferritiques entraîne en effet une formation d'une fraction trop importante de petits grains d'austénite, donc une formation insuffisante de martensite auto-revenue à l'issue du recuit, c'est à dire inférieure à 40%, en raison de l'abaissement de la valeur de la température $M_S$.

On chauffe ensuite la tôle laminée à froid depuis la température Ac1 jusqu'à une température de recuit $T_m$ comprise entre 780°C et (Ac3-25°C)

La température Ac3 peut être mesurée par dilatométrie ou calculée selon la formule : Ac3= 912 - 370- 27,4 Mn +27,3Si -6,35 Cr -32,7 Ni +95,2 V +190Ti +72 Al +64,5 Nb +5,57 W +332 S +276 P+ 485 N -900B +16,2 C Mn +32,3 C Si +15,4 C Cr+ 48 C Ni +4,32 Si Cr - 17,3 Si Mo -18,6 Si Ni +4,8 Mn Ni +40,5 Mo V+ 174 $C^2$+ 2,46 $Mn^2$ -6,86 $Si^2$ +0,322 $Cr^2$+ 9,9 $Mo^2$ +1,24 $Ni^2$ -60,2 $V^2$.

Dans cette formule, la température Ac3 est exprimée en degrés Celsius, et les teneurs élémentaires de la composition sont exprimées en pourcentages en poids.

Lorsque la température $T_m$ est inférieure à 780°C, la densité de précipités de (Ti, Nb, Mo)(CN) est telle que le durcissement peut induire une augmentation de Rm au delà de la valeur de 1320 MPa et à une moindre aptitude au formage.

Lorsque la température $T_m$ est supérieure à (Ac3-25°C), la taille de grain austénitique croît de façon de trop importante si bien que l'on forme une quantité excessive de bainite inférieure et de martensite autorevenue, au détriment de la martensite fraiche et qu'il n'est plus possible d'atteindre une résistance Rm de 1180 MPa.

On maintient la tôle laminée à froid à la température $T_m$ pendant une durée Dm comprise entre 30 et 150 secondes.

La durée Dm est choisie de telle sorte que la fraction des grains austénitiques dont la taille est inférieure à un micromètre représente de 40 à 60% de la population totale des grains austénitiques. Une durée de maintien Dm inférieure à 30s conduirait à la formation à l'issue du procédé d'une proportion trop importante de ferrite. La taille des grains austénitiques conditionne la cinétique de transformation de phase lors du refroidissement suivant le recuit. Notamment, les grains austénitiques de faible taille, inférieure à un micromètre, contribuent à abaisser la valeur de la température Ms et ainsi à diminuer la formation de martensite auto-revenue.

Le chauffage de la tôle laminée à froid à une vitesse moyenne de chauffage $V_C$ comprise entre 1°C/s et 20°C/s entre 600°C et la température Ac1, suivi du chauffage de la tôle laminée à froid entre Ac1 et $T_m$ et du maintien de la tôle laminée à froid à la température Tm pendant la durée Dm comprise entre 50 et 100 secondes permet ainsi de contrôler la taille des grains d'austénite formés, et plus particulièrement de contrôler la fraction de ces grains dont la taille est inférieure à un micromètre.

Ces paramètres de chauffage permettent d'obtenir la microstructure selon l'invention à l'issue du recuit et contribuent ainsi à l'obtention des caractéristiques mécaniques désirées.

Dans le cas d'une tôle destinée à être galvanisée ultérieurement, la tôle d'acier est ensuite refroidie à une vitesse $V_{R1}$ comprise entre 10 et 150°C/s jusqu'à une température Te comprise entre 400°C et 490°C. La vitesse de refroidissement doit être supérieure à 10°C/s afin de former moins de 5% de ferrite et de ne pas former trop de bainite à faible quantité de carbures.

Dans le cas de la fabrication d'une tôle nue, la tôle d'acier est refroidie à une vitesse $V_{R2}$ comprise entre 10 et 100°C/s jusqu'à une température Te comprise entre 400°C et 490°C.

Le refroidissement peut être effectué à partir de la température Tm, en une seule ou en plusieurs étapes et peut faire intervenir dans ce dernier cas différents modes de refroidissement tels que des bains d'eau froide ou bouillante, des jets d'eau ou de gaz.

On maintient alors la tôle à la température Te pendant une durée De comprise entre 5 et 150 secondes.

Une transformation partielle de l'austénite en bainite à faible quantité de carbures intervient à ce stade. Le maintien à Te doit être inférieur à 150s de façon à limiter la proportion surfacique de bainite et obtenir ainsi une proportion suffisante de martensite.

Les étapes suivantes du procédé diffèrent selon que l'on fabrique une tôle d'acier galvanisée en continu, notamment galvanisée-alliée, ou non revêtue.

Selon un premier mode de réalisation, correspondant à la fabrication d'une tôle d'acier galvanisée en continu, on revêt la tôle par passage en continu en immersion dans un bain de zinc ou en alliage de zinc à une température TZn comprise entre 450°C et 480°C, pendant quelques secondes. Les températures Te et TZn sont telles que 0°C ≤ (Te-TZn) ≤10°C.

On refroidit ensuite le produit galvanisé jusqu'à la température ambiante en transformant une grande fraction de l'austénite restante en martensite fraîche et/ou en bainite inférieure.

Dans le cas où l'on souhaite fabriquer une tôle d'acier laminée à froid, recuite et galvanisée-alliée (« galvannealed »), on chauffe le produit galvanisé immédiatement à la sortie du bain de zinc ou d'alliage de zinc à une température $T_G$ comprise entre 490 et 550°C pendant une durée $t_G$ comprise entre 10 et 40s. On provoque ainsi l'interdiffusion du fer et de la fine couche de zinc ou d'alliage de zinc déposée lors de l'immersion, ce qui permet d'obtenir une tôle galvanisée-alliée.

On refroidit ensuite la tôle galvanisée-alliée jusqu'à la température ambiante en transformant une grande fraction de l'austénite restante en martensite fraîche et/ou en bainite inférieure.

Dans tous les modes de réalisation décrits ci-dessus, on obtient de la sorte une tôle d'acier laminée à froid et recuite contenant en proportion surfacique, une somme de 40 à 70% de martensite et de bainite inférieure, de 15 à 45% de bainite à faible quantité de carbures, de 5 à moins de 20% de ferrite, et moins de 5% d'austénite résiduelle sous forme d'îlots.

Les inventeurs ont mis en évidence que la mise en œuvre de ce procédé permet d'obtenir une tôle d'acier présentant une résistance mécanique comprise entre 1180 et 1320 MPa, conjointement avec une limite d'élasticité comprise entre 750 et 970 MPa (avant toute opération de skin-pass), un allongement à rupture d'au moins 7%, voire 8%, dont le rapport d'expansion de trou Ac% est supérieur ou égal à 20%.

En outre, la mise en œuvre de ce procédé permet d'assurer à la tôle un angle de pliage d'au moins 40° lorsque la tôle a une épaisseur comprise entre 0,7 mm et 2mm.

Par ailleurs, la tôle obtenue présente une bonne aptitude au soudage au moyen des procédés d'assemblage usuels tels que le soudage par résistance par points.

A titre d'exemple non limitatif, les résultats suivants vont montrer les caractéristiques avantageuses conférées par l'invention.

On a approvisionné des demi-produits d'acier dont les compositions, exprimées en teneurs pondérales (%) sont présentées dans le tableau 1 ci-dessous.

Outre les aciers I1 à I3 ayant servi à la fabrication de tôles selon l'invention, on a indiqué à titre de comparaison la composition d'aciers R1 à R5 ayant servi à la fabrication de tôles de référence.

On a mesuré par dilatométrie, ou calculé la température Ac3 au moyen de la formule mentionnée ci-dessus et rapporté ces valeurs dans le tableau 1.

Tableau 1- Compositions d'aciers- Température Ac3

|  | C % | Mn % | Si % | Cr % | Ti % | B % | Al % | Mo % | Nb % | N % | S % | P % | Ca % | Ac3 (°C) |
|---|---|---|---|---|---|---|---|---|---|---|---|---|---|---|
| I1 | 0,099 | 2,67 | 0,384 | 0,294 | 0,031 | 0,0018 | 0,127 | 0,088 | 0,024 | 0,004 | 0,003 | 0,015 | <0,003 | 853 |
| I2 | 0,09 | 2,69 | 0,313 | 0,3 | 0,028 | 0,002 | 0,153 | 0,09 | 0,024 | 0,004 | 0,003 | 0,010 | <0,003 | 855 |
| I3 | 0,107 | 2,69 | 0,338 | 0,3 | 0,035 | 0,002 | 0,133 | 0,09 | 0,025 | 0,007 | 0,003 | 0,015 | <0,003 | 844 |
| R1 | 0,134 | 2,515 | 0,536 | 0,574 | 0,043 | 0,0045 | 0,017 | 0,002 | 0,031 | 0,006 | 0,003 | 0,015 | <0,003 | 838 |
| R2 | 0,086 | 2,492 | 0,309 | 0,519 | 0,040 | 0,0039 | 0,028 | 0,003 | 0,028 | 0,005 | 0,003 | 0,015 | <0,003 | 830 |
| R3 | 0,087 | 2,584 | 0,310 | 0,520 | 0,039 | 0,0038 | 0,025 | 0,003 | 0,034 | 0,005 | 0,003 | 0,015 | <0,003 | 830 |
| R4 | 0,079 | 2,52 | 0,251 | 0,310 | 0,022 | 0,002 | 0,150 | 0,09 | 0,024 | 0,004 | 0,003 | 0,010 | <0,003 | 853 |
| R5 | 0,117 | 2,245 | 0,507 | 0,515 | 0,029 | 0,0035 | 0,029 | 0,002 | 0,018 | 0,005 | 0,003 | 0,015 | <0,003 | 830 |
| Valeurs soulignées : non-conformes à l'invention. | | | | | | | | | | | | | | |

Des demi-produits coulés correspondant aux compositions ci-dessus ont été réchauffés à une température $T_R$ supérieure à 1250°C, puis laminés à chaud, la température de fin de laminage étant égale à 850°C, supérieure à Ar3 pour tous ces aciers.

Les tôles laminées à chaud ont été refroidies en évitant la formation de ferrite et de perlite, puis bobinées à une température de 545°C. Les tôles ont ensuite été laminées à froid jusqu'à une épaisseur de 1,4 mm.

Dans un premier ensemble d'essais, des tôles I1 ont été ensuite chauffées avec une vitesse de chauffage $V_C$, entre 600°C et Ac1, Ac1 désignant la température de début de transformation austénitique au chauffage, puis ensuite de Ac1 jusqu'à une température Tm et maintenues à la température Tm pendant une durée Dm.

Les tôles ont été refroidies à une vitesse $V_{R1}$ jusqu'à une température Te, puis maintenues à la température Te pendant une durée De.

Lors d'un essai particulier (I1F), la tôle I1 a été réchauffée jusqu'à 810°C, maintenue pendant 120s à cette température, puis refroidie par trempe à l'eau avec une vitesse supérieure à 100°C/s jusqu'à la température ambiante, c'est-à-dire sans étape de maintien à la température Te.

Ces essais ont été réalisés selon différentes conditions de traitement (A à H), indiquées dans le tableau 2. Dans ce tableau, « n.a. » signifie : non applicable. En effet, selon le traitement F, aucun maintien à une température Te n'est effectué si bien qu'on ne peut donc définir un temps de maintien De pertinent.

Selon un second ensemble d'essais, les nuances R1-R5 ont été traitées selon des conditions définies au tableau 3.

Les tôles fabriquées dans toutes les conditions ci-dessus ont été ensuite revêtues par revêtement au trempé en continu dans un bain de zinc à 460°C puis chauffées immédiatement à 510°C de façon à obtenir un revêtement galvanisé-allié.

Tableau 2 : Conditions d'essais réalisées sur la nuance I1

| Traitement | $V_C$ entre 600 et Ac1 (°C/s) | Tm (°C) | Dm (s) | $V_{R1}$ (°C/s) | Te (°C) | De (s) |
|---|---|---|---|---|---|---|
| A | 2 | 810 | 120 | 30 | 460 | 130 |
| B | 2 | <u>830</u> | 120 | 30 | 460 | 130 |
| C | 6 | 820 | 60 | 26 | 470 | 33 |
| D | <u>0,2</u> | 810 | <u>2</u> | 26 | 460 | 33 |
| E | <u>0,2</u> | 810 | 60 | 26 | 460 | 33 |
| F | 2 | 810 | 120 | >100°C/s | <u>20</u> | n.a. |
| G | 2 | 780 | <u>2</u> | 26°C/s | 460 | 33 |
| H | 2 | <u>760</u> | 120 | 18 | 470 | 100 |

Valeurs soulignées : non-conformes à l'invention.

Tableau 3 : Conditions d'essais réalisées sur les nuances I2, I3 et R1 à R5

| Traitement | $V_C$ entre 600 et Ac1 (°C/s) | Tm (°C) | Dm (s) | $V_{R1}$ (°C/s) | Te (°C) | De (s) |
|---|---|---|---|---|---|---|
| A | 2 | 810 | 120 | 30 | 460 | 130 |
| B | 2 | 830 | 120 | 30 | 460 | 130 |
| C | 6 | 820 | 60 | 26 | 470 | 33 |
| I | 8 | 805 | 50 | 30 | 470 | 40 |
| J | 2 | 780 | 140 | 18 | 460 | 120 |

On a déterminé les caractéristiques mécaniques des tôles ainsi obtenues, résultant de la composition d'acier et du traitement thermique. Par convention, les tôles ont été repérées en associant la dénomination de la composition chimique et du traitement thermique : ainsi I1A désigne la tôle obtenue à partir de la composition I1 sur laquelle on a appliqué les conditions du traitement thermique A.

Au moyen d'essais de traction, on a déterminé la limite d'élasticité Re, la résistance à la rupture Rm et l'allongement total At des tôles obtenues par ces différents modes de fabrication. On a également déterminé l'aptitude au pliage de ces tôles en déterminant l'angle maximal avant rupture.

Cet angle est déterminé en appliquant un poinçon sur les tôles de manière à plier celles-ci. La force à appliquer pour réaliser le pliage croît jusqu'à la rupture. La mesure de la force appliquée lors du pliage permet ainsi de détecter l'amorçage de la rupture de la tôle, et de mesurer l'angle maximal de pliage lorsque cette rupture intervient.

On a par ailleurs déterminé le rapport d'expansion de trou Ac% de chaque tôle en effectuant un trou de 10 mm de diamètre par découpe dans la tôle, puis au moyen d'un outil tronconique en réalisant une expansion au niveau des bords de ce trou. Comme décrit dans la norme ISO 16630:2009, on a mesuré le diamètre initial Di du trou avant emboutissage, puis le diamètre final Df du trou après emboutissage, au moment où l'on observe des fissures traversantes dans l'épaisseur de la tôle sur les bords du trou. On a déterminé l'aptitude à l'expansion de trou Ac% selon la formule suivante :

$$Ac\% = 100 * \frac{D_f - D_i}{D_i} .$$

On a également déterminé les caractéristiques de la microstructure des aciers. Les fractions surfaciques de martensite (incluant la martensite auto-revenue et la martensite fraîche) et de bainite inférieure (conjointement), de martensite auto-revenue et de bainite inférieure (conjointement), et de bainite à faible quantité de carbures ont été quantifiées sur des coupes polies soumises à une attaque au bisulfite de sodium. La fraction surfacique de martensite fraîche a été quantifiée après attaque par un réactif NaOH-NaNO3.

On a également déterminé la fraction surfacique de ferrite grâce à des observations en microscopie optique et électronique à balayage où l'on a identifié la phase ferritique.

On a également observé la nature, la taille et la densité des précipités sur lame mince en microscopie électronique à transmission.

Les détails concernant les microstructures des tôles ont été portés au tableau 4 ci-dessous.

Tableau 4 - Caractéristiques microstructurales des tôles obtenues

| | (Martensite +bainite inférieure) (%) | (Martensite auto-revenue + bainite inférieure) (%) | Martensite fraîche (%) | Bainite à faible quantité de carbures (%) | Austénite (%) | Ferrite (%) | Fraction de grains austénitiques dont la taille est <1 micron | densité de (Ti,Nb,Mo) (C N)de taille<5 nm< <10000/$\mu^3$? |
|---|---|---|---|---|---|---|---|---|
| I1A | 50 | 5 | 45 | 43 | 0 | 7 | 50 | Oui |
| I1B | 40 | 10 | 30 | <u>57</u> | 0 | 3 | <u>15</u> | Oui |
| I1C | 60 | 45 | 15 | 25 | 0 | 15 | n.d. | Oui |
| I1D | <u>22</u> | 2 | 20 | 38 | 0 | <u>40</u> | 10 | Oui |
| I1E | <u>25</u> | 5 | 20 | 35 | 0 | <u>40</u> | 10 | Oui |
| I1F | <u>93</u> | <u>78</u> | 15 | <u>0</u> | 2 | 5 | 50 | Oui |
| I1G | 40 | 3 | 37 | 35 | 0 | <u>25</u> | <u>70</u> | Oui |
| I1H | 40 | 0 | 40 | 25 | 2 | <u>33</u> | <u>80</u> | <u>Non</u> |
| I2J | 40 | 5 | 35 | 45 | 0 | 15 | 60 | Oui |
| I3I | 70 | 30 | 40 | 15 | 0 | 15 | 55 | Oui |
| R1B | <u>95</u> | 81 | <u>14</u> | 3 | 0 | <u>2</u> | 5 | Oui |
| R2B | 60 | 30 | 30 | 40 | 0 | <u>0</u> | 10 | Oui |
| R3B | <u>75</u> | 45 | 30 | 25 | 0 | <u>0</u> | 10 | Oui |
| R3C | 60 | 30 | 30 | 38 | 0 | <u>2</u> | 15 | Oui |
| R4J | <u>25</u> | 0 | 25 | 40 | 0 | <u>35</u> | 60 | Oui |
| R5B | <u>50</u> | 25 | 25 | <u>50</u> | 0 | 0 | 5 | Oui |
| R5C | 45 | 23 | 22 | <u>47</u> | 0 | 8 | <u>7</u> | Oui |

Valeurs soulignées : non-conformes à l'invention.

n.d. : non déterminé

Les propriétés mécaniques des tôles ont été portées au tableau 5 ci-dessous.

Tableau 5 - Propriétés mécaniques des tôles obtenues

| | Re (MPa) | Rm (MPa) | At (%) | Angle de pliage (°) | Ac% |
|---|---|---|---|---|---|
| I1A | 793 | 1210 | 7,5 | 57 | 20 |
| I1B | 803 | <u>1166</u> | 8 | n.d. | 25 |
| I1C | 803 | 1253 | 9,5 | 60 | n.d. |
| I1D | <u>621</u> | <u>1063</u> | 9,2 | n.d. | 25 |
| I1E | <u>636</u> | <u>1069</u> | 9,2 | n.d. | 25 |
| I1F | <u>1054</u> | <u>1370</u> | <u>6,7</u> | n.d. | 37 |
| I1G | 756 | 1237 | 10,1 | n.d. | <u>18</u> |
| I1H | 856 | <u>1327</u> | 7,5 | n.d. | 15. |

(suite)

|  | Re (MPa) | Rm (MPa) | At (%) | Angle de pliage (°) | Ac% |
|---|---|---|---|---|---|
| I2J | 763 | 1206 | 11 | 25 | 22 |
| I3 I | 770 | 1270 | 8,1 | 44 | 21 |
| R1B | 930 | <u>1353</u> | 7,3 | 56 | 43,9 |
| R2B | 800 | <u>1116</u> | 8 | 71 | n.d. |
| R3B | 821 | <u>1131</u> | 7,6 | 56 | n.d. |
| R3C | 798 | <u>1165</u> | 8,6 | n.d. | 37 |
| R4J | <u>669</u> | <u>1095</u> | 13,4 | 63 | 28 |
| R5B | 790 | <u>1151</u> | <u>6,7</u> | 63 | n.d. |
| R5C | <u>720</u> | <u>1137</u> | 10,4 | n.d. | 30 |

n.d : non déterminé.

On met ainsi en évidence les relations entre les compositions des aciers, leur microstructure et leurs propriétés mécaniques.

Les tôles d'acier selon l'invention présentent une composition et une microstructure qui permettent d'obtenir une résistance mécanique, une limite d'élasticité, un allongement, un angle de pliage et un rapport d'expansion de trou qui satisfont aux valeurs visées.

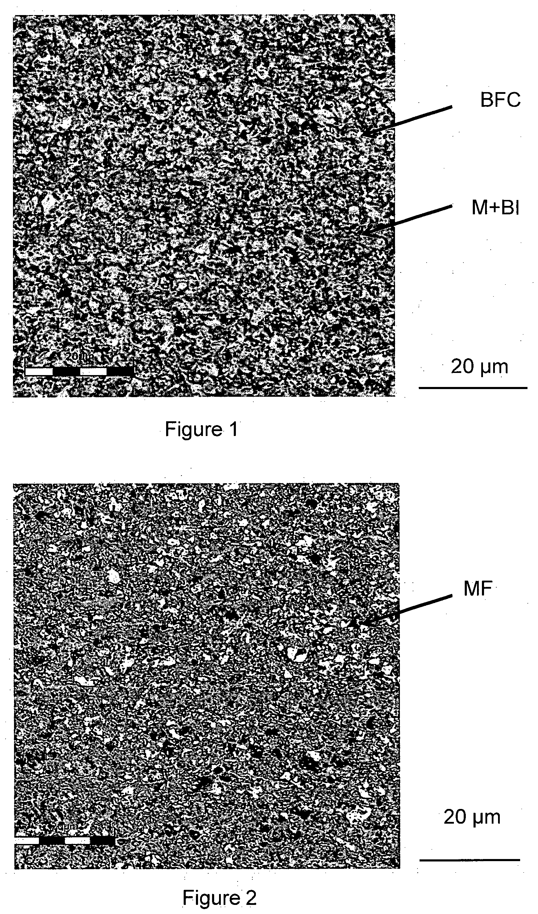

Les Figures 1 et 2 illustrent la microstructure de l'exemple I1A. La Figure 1 montre le résultat d'une attaque de la tôle par bisulfite de sodium, tandis que la Figure 2 illustre le résultat de l'attaque de la tôle par le réactif NaOH-NaNO3. La Figure 1 fait apparaître la martensite auto-revenue et la bainite inférieure (M+BI), ainsi que la bainite à faible quantité de carbures (BFC). La Figure 2 fait apparaître, sous forme de zones plus sombres, la martensite fraîche (MF).

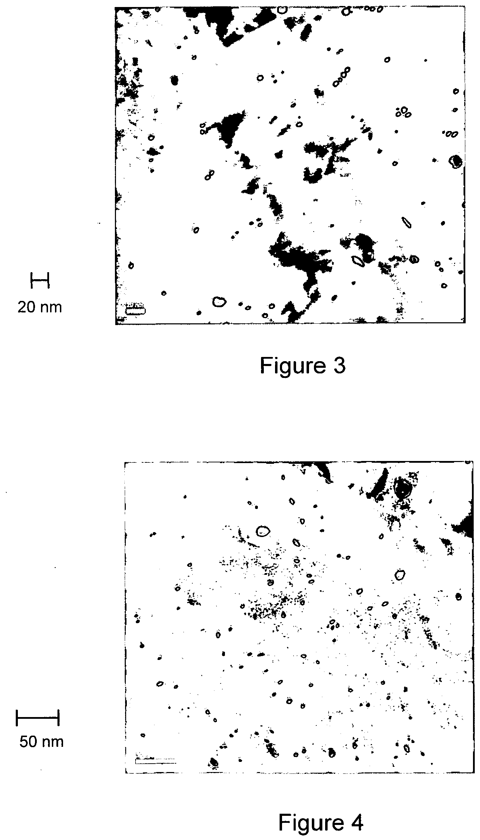

Dans l'essai I1A, les observations en MET (figure 3) révèlent la présence de carbonitrures (Ti, Nb, Mo)(CN) d'une taille moyenne de 7 nm, en quantité inférieure à 10000 précipités/$\mu$m$^3$, si bien que l'ensemble des propriétés mécaniques désirées est atteint. Ces observations mettent également en évidence la présence de carbures sous forme de bâtonnets orientés dans les directions <111> dans les lattes de martensite auto-revenue et de bainite inférieure. La bainite à faible quantité de carbures contient moins de 100 carbures par unité de surface de 100 micromètres carrés.

Dans l'essai I1B, la température de recuit Tm est trop proche de AC3, ce qui conduit à une faible quantité de carbone dans l'austénite. Il se forme trop de bainite à faible quantité de carbures pendant le refroidissement et le maintien à la température Te. Ceci se traduit par une résistance mécanique trop faible.

Dans les essais I1D et I1E, la vitesse de chauffage Vc est trop faible. Ainsi, on observe une croissance trop importante des grains de ferrite. Il subsiste ainsi dans l'acier une quantité trop importante de ferrite et il n'y a pas assez de martensite ou de bainite inférieure. La résistance mécanique Rm n'est donc pas atteinte même pour des temps de maintien Dm de 60s comme c'est le cas pour l'exemple I1E.

Dans l'essai I1F la vitesse de refroidissement $V_R$ est trop élevée. Ainsi, il se forme trop de martensite et de bainite inférieure, et pas assez de bainite à faible quantité de carbures et de martensite fraîche. La résistance mécanique et la limite d'élasticité sont donc bien au-delà de celles visées tandis que l'allongement est trop faible.

Le temps de maintien Dm à température Tm du traitement G est trop court si bien que la tôle produite suivant la condition I1G présente un taux de recristallisation de la ferrite inférieur à 15%. Ceci génère une structure en bandes qui conduit à une faible valeur d'expansion de trou.

Dans l'essai I1H, la température de recuit trop faible conduit à une trop grande densité de précipités de petite taille : les observations en MET (figure 4) font apparaître une taille moyenne de 5 nm en quantité supérieure à 10000 précipités/$\mu$m$^3$ si bien que la résistance mécanique excède 1320 MPa. De plus la faible température de recuit Tm ne permet pas d'atteindre un taux de recristallisation de la ferrite supérieur à 15% ce qui conduit à une valeur d'expansion de trou trop basse.

Dans le cas des essais I1G et I1H, la fraction de grains austénitiques dont la taille est inférieure à 1 $\mu$m est trop importante, ce qui induit une température Ms trop basse, et donc la formation d'une quantité de bainite inférieure plus martensite auto-revenue trop faible. Ceci contribue à diminuer l'expansion de trou qui est trop faible pour ces deux essais.

La tôle selon l'exemple R1B présente des teneurs en C, Cr, Ti et B trop élevées, de telle sorte que sa résistance mécanique Rm est trop élevée malgré une quantité de Mo trop faible. Ainsi, bien que l'on obtienne une limite d'élasticité Re satisfaisante, celle-ci d'élasticité est obtenue conjointement avec une résistance mécanique Rm trop élevée. Les tôles selon les essais R2B, R3B et R3C contiennent des teneurs en C et Mn et Mo trop faibles, et ne présentent ainsi pas une résistance mécanique satisfaisante bien que les quantités de B et Cr soient très élevées.

L'exemple R5 présente une teneur en Mn trop faible, ce qui conduit à une formation trop importante de bainite à faible quantité de carbures selon les traitements B et C.

Les tôles d'aciers selon l'invention seront utilisées avec profit pour la fabrication de pièces de structures ou de sécurité dans l'industrie automobile.

**Revendications**

1. Tôle d'acier laminée à froid et recuite d'épaisseur comprise entre 0,7 mm et 2mm, de résistance mécanique comprise entre 1180 MPa et 1320 MPa, dont le rapport d'expansion de trou Ac% est supérieur à 20% et l'angle de pliage supérieur ou égal à 40°, dont la composition chimique comprend, les teneurs étant exprimées en poids :

$$0{,}09 \leq C \leq 0{,}11 \ \%$$

$$2{,}6 \leq Mn \leq 2{,}8\%$$

$$0{,} 20 \leq Si \leq 0{,}55\%$$

$$0{,} 25 \leq Cr \leq 0{,}5 \ \%$$

$$0{,}025 \leq Ti \leq 0{,}040 \ \%$$

$$0{,}0015 \leq B \leq 0{,}0025 \ \%$$

$$0{,}005 \leq Al < 0{,}18 \ \%$$

$$0{,}08 \leq Mo < 0{,}15 \ \%$$

$$0{,}020 \leq Nb \leq 0{,}040\%$$

$$0{,}002 \leq N \leq 0{,}007 \ \%$$

$$0{,}0005\% \leq S \leq 0{,}005\%$$

$$0{,}001\% \leq P \leq 0{,}020\%,$$

$$Ca < 0{,}003\%$$

le reste étant constitué de fer et d'impuretés inévitables provenant de l'élaboration, la tôle ayant une microstructure constituée de martensite et/ou de bainite inférieure, ladite martensite comprenant de la martensite fraîche et/ou de la martensite auto-revenue, la somme des proportions surfaciques, mesurées comme défini dans la description, de martensite et
de bainite inférieure étant comprise entre 40 à 70%, de 15 à 45% en proportion surfacique de bainite à faible quantité de carbures, de 5 à moins de 20% en proportion surfacique de ferrite, la fraction de ferrite non recristallisée par rapport à la fraction de ferrite totale, étant inférieure à 15%, et de moins de 5% en proportion surfacique d'austénite résiduelle sous forme d'îlots, la fraction des anciens grains austénitiques dont la taille est inférieure à moins de un micromètre représentant de 40 à 60% de la population totale desdits anciens grains austénitiques.

2. Tôle d'acier selon la revendication 1, **caractérisée en ce que** ladite microstructure comprend en proportion surfacique de 15 à 45% de martensite fraîche.

3. Tôle d'acier selon la revendication 1, caractérisée ce que ladite microstructure comprend en proportion surfacique de 5 à 50% de somme de martensite auto-revenue et de bainite inférieure

4. Tôle d'acier selon la revendication 3, **caractérisée en ce que** ladite martensite auto-revenue et ladite bainite inférieure contiennent des carbures sous forme de bâtonnets orientés dans les directions <111> des lattes martensitiques et bainitiques comme mesurés et identifiés selon la description.

5. Tôle d'acier selon l'une quelconque des revendications 1 à 4, **caractérisée en ce que** ladite bainite à faible quantité de carbures contient moins de 100 carbures par unité de surface de 100 micromètres carrés, mesurés comme défini dans la description.

6. Tôle d'acier selon l'une quelconque des caractéristiques 1 à 5, **caractérisée en ce qu'**elle contient des précipités du type (Ti, Nb, Mo)(C,N) de taille inférieure à 5 nanomètres, présents en quantité inférieure à 10 000 précipités / $\mu m^3$.

7. Tôle d'acier selon l'une quelconque des revendications 1 à 6, **caractérisée en ce que** la composition chimique comprend, la teneur étant exprimée en poids :

$$2,6 < Mn \leq 2,7\%.$$

8. Tôle d'acier selon l'une quelconque des revendications 1 à 7, **caractérisée en ce que** la composition chimique comprend, la teneur étant exprimée en poids :

$$0,30 < Si \leq 0,5\%.$$

9. Tôle d'acier selon l'une quelconque des revendications 1 à 8, **caractérisée en ce que** la composition chimique comprend, la teneur étant exprimée en poids :

$$0,005 < Al < 0,030\%.$$

10. Procédé de fabrication d'une tôle laminée à froid et recuite selon l'une quelconque des revendications 1 à 9, comprenant les étapes successives suivantes : - on approvisionne un demi-produit dont la composition chimique comprend, les teneurs étant exprimées en poids :

$$0,09 < C \leq 0,11 \%$$

$$2,6 \leq Mn < 2,8\%$$

$$0,20 < Si \leq 0,55\%$$

$$0,25 \leq Cr < 0,5 \%$$

$$0,025 < Ti < 0,040 \%$$

$$0,0015 \leq B \leq 0,0025 \%$$

$$0,005 \leq Al \leq 0,18 \%$$

$$0,08 \leq Mo \leq 0,15 \%$$

$$0,020 \leq Nb < 0,040\%$$

$$0,002 < N < 0,007 \ \%$$

$$0,0005\% \leq S < 0,005\%$$

$$0,001\% \leq P < 0,020\%,$$

$$Ca \leq 0,003\%$$

le reste étant constitué de fer et d'impuretés inévitables provenant de l'élaboration, puis

- on chauffe ledit demi-produit à une température $T_r$ supérieure ou égale à 1250°C, puis
- on lamine à chaud ledit demi-produit, la température de fin de laminage étant supérieure à la température Ar3 de début de transformation de l'austénite au refroidissement, pour obtenir une tôle laminée à chaud, puis
- on refroidit ladite tôle laminée à chaud à une vitesse supérieure à 30°C/s pour éviter la formation de ferrite et de perlite, puis
- on bobine ladite tôle laminée à chaud à une température comprise entre 580° et 500°C, puis
- on lamine à froid ladite tôle laminée à chaud pour obtenir une tôle laminée à froid, puis
- on réchauffe ladite tôle laminée à froid entre 600°C et Ac1, Ac1 désignant la température de début de transformation austénitique au chauffage, avec une vitesse de réchauffage $V_c$ comprise entre 1 et 20°C/s, puis
- on porte ladite tôle laminée à froid jusqu'à une température Tm comprise entre 780°C et (Ac3-25°C), et on maintient à ladite température Tm ladite tôle laminée à froid pendant une durée Dm comprise entre 30 et 150 secondes, étant entendu que Ac3 désigne la température de fin de transformation austénitique au chauffage, puis - on refroidit la tôle à une vitesse VR1 comprise entre 10 et 150°C/s jusqu'à une température Te comprise entre 400 et 490°C, puis
- on maintient la tôle à la température Te pendant une durée De comprise entre 5 et 150 secondes, puis
- on revêt la tôle par passage en continu en immersion dans un bain de zinc ou en alliage de zinc à une température TZn comprise entre 450°C et 480°C, lesdites températures Te et TZn étant telles que 0< (Te-TZn)≤10°C, de façon à obtenir une tôle revêtue, puis
- on réchauffe optionnellement ladite tôle revêtue à une température $T_G$ comprise entre 490°C et 550°C pendant une durée $t_G$ comprise entre 10 s et 40 s.

**11.** Utilisation d'une tôle d'acier selon l'une quelconque des revendications 1 à 9, ou fabriquée par un procédé selon la revendication 10, pour la fabrication de pièces de structures ou de sécurité pour véhicules automobiles.

**Patentansprüche**

**1.** Kaltgewalztes und geglühtes Stahlblech mit einer Stärke zwischen 0,7 mm und 2mm, einer Festigkeit zwischen 1180 MPa und 1320 MPa, dessen Lochausdehnungsverhältnis Ac% größer als 20 % und dessen Biegewinkel größer als oder gleich wie 40° ist, dessen chemische Zusammensetzung Folgendes umfasst, wobei der Gehalte nach Gewicht ausgedrückt ist:

$$0,09 \leq C \leq 0,11 \ \%$$

$$2,6 \leq Mn \leq 2,8 \ \%$$

$$0,20 \leq Si \leq 0,55 \ \%$$

$$0,25 \leq Cr \leq 0,5 \ \%$$

$$0,025 \leq Ti \leq 0,040 \ \%$$

$$0,0015 \leq B \leq 0,0025 \ \%$$

$$0,005 \leq Al < 0,18\ \%$$

$$0,08 \leq Mo < 0,15\ \%$$

$$0,020 \leq Nb \leq 0,040\ \%$$

$$0,002 \leq N \leq 0,007\ \%$$

$$0,0005\ \% \leq S \leq 0,005\ \%$$

$$0,001\ \% \leq P \leq 0,020\ \%,$$

$$Ca < 0,003\ \%$$

wobei der Rest aus Eisen und unvermeidbaren Verunreinigungen aus der Verarbeitung besteht, wobei das Blech eine Mikrostruktur aufweist, die aus Martensit und/oder unterem Bainit besteht, der Martensit umfassend frischen Martensit und/oder selbsterzeugten Martensit, wobei die Summe der Flächenanteile, gemessen wie definiert in der Beschreibung, von Martensit und

unterem Bainit zwischen 40 und 70 % liegt, von 15 bis 45 % Flächenanteil von Bainit mit geringer Karbidmenge, 5 bis weniger als 20 % Flächenanteil von Ferrit, wobei der Anteil von nicht rekristallisiertem Ferrit im Verhältnis zu dem gesamten Ferritanteil, weniger als 15 % ist, und weniger als 5 % Flächenanteil an inselförmigem Restaustenit, wobei die Fraktion der alten Austenitkörner mit einer Größe von weniger als einem Mikrometer 40 bis 60 % der Gesamtpopulation der alten Austenitkörner darstellt.

2. Stahlblech nach Anspruch 1, **dadurch gekennzeichnet, dass** die Mikrostruktur in Flächenanteilen von 15 bis 45 % frischen Martensit enthält.

3. Stahlblech nach Anspruch 1, **dadurch gekennzeichnet, dass** die Mikrostruktur in Flächenanteilen von 5 bis 50 % die Summe aus selbsterzeugtem Martensit und unterem Bainit umfasst.

4. Stahlblech nach Anspruch 3, **dadurch gekennzeichnet, dass** der selbsterzeugte Martensit und der untere Bainit Karbide in Form von Stäbchen enthalten, die in den Richtungen <111> der martensitischen und bainitischen Latten ausgerichtet sind, wie sie gemäß der Beschreibung gemessen und identifiziert werden.

5. Stahlblech nach einem der Ansprüche 1 bis 4, **dadurch gekennzeichnet, dass** das Bainit mit geringer Karbidmenge weniger als 100 Karbide pro Flächeneinheit von 100 Quadratmikrometern enthält, gemessen wie definiert in der Beschreibung.

6. Stahlblech nach einem der Merkmale 1 bis 5, **dadurch gekennzeichnet, dass** es Präzipitate vom Typ (Ti, Nb, Mo) (C,N) mit einer Größe von weniger als 5 Nanometern enthält, die in einer Menge von weniger als 10.000 Präzipitate / $\mu m^3$ vorhanden sind.

7. Stahlblech nach einem der Ansprüche 1 bis 6, **dadurch gekennzeichnet, dass** die chemische Zusammensetzung Folgendes umfasst, wobei der Gehalt in Gewicht ausgedrückt ist:

$$2,6 < Mn \leq 2,7\ \%.$$

8. Stahlblech nach einem der Ansprüche 1 bis 7, **dadurch gekennzeichnet, dass** die chemische Zusammensetzung Folgendes umfasst, wobei der Gehalt in Gewicht ausgedrückt ist:

$$0,30 < Si \leq 0,5\ \%.$$

9. Stahlblech nach einem der Ansprüche 1 bis 8, **dadurch gekennzeichnet, dass** die chemische Zusammensetzung Folgendes umfasst, wobei der Gehalt in Gewicht ausgedrückt ist:

0,005 < Al < 0,030 %.

10. Verfahren zur Herstellung eines kaltgewalzten und geglühten Blechs nach einem der Ansprüche 1 bis 9, umfassend die folgenden aufeinanderfolgenden Schritte: - Bereitstellen eines Halbfabrikats, dessen chemische Zusammensetzung Folgendes umfasst, wobei der Gehalt in Gewicht ausgedrückt ist:

$$0,09 < C \leq 0,11 \%$$

$$2,6 \leq Mn < 2,8 \%$$

$$0,20 < Si \leq 0,55 \%$$

$$0,25 \leq Cr < 0,5 \%$$

$$0,025 < Ti < 0,040 \%$$

$$0,0015 \leq B \leq 0,0025 \%$$

$$0,005 \leq Al \leq 0,18 \%$$

$$0,08 \leq Mo \leq 0,15 \%$$

$$0,020 \leq Nb < 0,040 \%$$

$$0,002 < N < 0,007 \%$$

$$0,0005 \% \leq S < 0,005 \%$$

$$0,001 \% \leq P < 0,020 \%,$$

$$Ca \leq 0,003 \%$$

wobei der Rest aus Eisen und unvermeidbaren Verunreinigungen besteht, die aus der Herstellung stammen, dann

- Erhitzen des Halbfabrikats auf eine Temperatur $T_r$ von 1250°C oder höher, dann
- Warmwalzen des Halbfabrikats, wobei die Walzendtemperatur höher ist als die Temperatur Ar3 bei Beginn der Umwandlung des Austenits beim Abkühlen, um ein warmgewalztes Blech zu erlangen, dann
- Abkühlen des warmgewalzten Blechs mit einer Geschwindigkeit von mehr als 30 °C/Sek., um die Bildung von Ferrit und Perlit zu verhindern, dann
- Aufwickeln des warmgewalzten Blechs bei einer Temperatur zwischen 580 ° und 500 °C, dann
- Kaltwalzen des warmgewalzten Blechs, um ein kaltgewalztes Blech zu erlangen, dann
- Wiedererhitzen des kaltgewalzten Blechs zwischen 600°C und Ac1, wobei Ac1 die Temperatur bei Beginn der austenitischen Umwandlung beim Erhitzen bezeichnet, mit einer Erhitzungsgeschwindigkeit $V_c$ zwischen 1 und 20 °C/Sek., dann
- Bringen des kaltgewalzten Blechs auf eine Temperatur Tm zwischen 780 °C und (Ac3-25 °C) und Halten des kaltgewalzten Blechs über eine Dauer Dm zwischen 30 und 150 Sekunden auf dieser Temperatur Tm, wobei Ac3 die Endtemperatur der austenitischen Umwandlung beim Erhitzen bezeichnet, dann - Abkühlen des Blechs mit einer Geschwindigkeit VR1 zwischen 10 und 150 °C/Sek. auf eine Temperatur Te zwischen 400 und 490 °C, dann
- Halten des Blechs auf der Temperatur Te über eine Dauer De zwischen 5 und 150 Sekunden, dann

- Beschichten des Blechs durch kontinuierliches Eintauchen in ein Bad aus Zink oder einer Zinklegierung bei einer Temperatur TZn zwischen 450 °C und 480°C, wobei die Temperaturen Te und TZn derart sind, dass 0< (Te-TZn)≤10 °C, sodass ein beschichtetes Blech erlangt wird, dann
- optional Wiedererhitzen des beschichteten Blechs auf eine Temperatur TG zwischen 490 °C und 550 °C über eine Dauer tG zwischen 10 Sek. und 40 Sek.

**11.** Verwendung eines Stahlblechs nach einem der Ansprüche 1 bis 9 oder hergestellt durch ein Verfahren nach Anspruch 10 zur Herstellung von Struktur- oder Sicherheitsteilen für Kraftfahrzeuge.

**Claims**

**1.** Cold-rolled and annealed steel sheet with a thickness of between 0.7 mm and 2mm, a mechanical strength of between 1180 MPa and 1320 MPa, a hole expansion ratio Ac% of greater than 20% and a bending angle of greater than or equal to 40°, the chemical composition of which comprises, the contents being expressed by weight:

$$0.09 \leq C \leq 0.11 \%$$

$$2.6 \leq Mn \leq 2.8\%$$

$$0.20 \leq Si \leq 0.55\%$$

$$0.25 \leq Cr \leq 0.5\%$$

$$0.025 \leq Ti \leq 0.040\%$$

$$0.0015 \leq B \leq 0.0025\%$$

$$0.005 \leq Al < 0.18\%$$

$$0.08 \leq Mo < 0.15\%$$

$$0.020 \leq Nb \leq 0.040\%$$

$$0.002 \leq N \leq 0.007\%$$

$$0.0005\% \leq S \leq 0.005\%$$

$$0.001\% \leq P \leq 0.020\%,$$

$$Ca < 0.003\%$$

the remainder being iron and unavoidable impurities from the smelting process, the sheet having a microstructure consisting of martensite and/or lower bainite, said martensite comprising fresh martensite and/or self-annealed martensite, the sum of the surface proportions, measured as defined in the description, of martensite and of lower bainite being between 40 and 70%, from 15 to 45% as a surface proportion of bainite with a low quantity of carbides, from 5 to less than 20% as a surface proportion of ferrite, the fraction of non-recrystallized ferrite with respect to the fraction of total ferrite being less than 15%, and less than 5% as a surface proportion of residual austenite in the form of islands, the fraction of old austenitic grains whose size is less than one micrometre representing from 40 to 60% of the total population of the said old austenitic grains.

**2.** Steel sheet according to claim 1, **characterised in that** the said microstructure comprises a surface proportion of 15 to 45% of fresh martensite.

3. Steel sheet according to claim 1, **characterised in that** the said microstructure comprises, in a surface proportion of 5 to 50%, the sum of autogenous martensite and lower bainite

4. A steel sheet according to claim 3, **characterised in that** said self-arising martensite and said lower bainite contain carbides in the form of rods oriented in the <111> directions of the martensitic and bainitic laths as measured and identified according to the description.

5. A steel sheet according to any one of claims 1 to 4, **characterised in that** said low carbide bainite contains less than 100 carbides per 100 square micrometre unit area, measured as defined in the description.

6. Steel sheet according to any one of characteristics 1 to 5, **characterised in that** it contains precipitates of the types of the $(Ti, Nb, Mo)(C,N)$ type with a size of less than 5 nanometres, present in a quantity of less than 10,000 precipitates / $\mu m^3$.

7. A manufacturing method according to any one of claims 1 to 6, **characterised in that** the chemical composition comprises, the content being expressed by weight:

$$2.6 < Mn \leq 2.7\%.$$

8. A manufacturing method according to any one of claims 1 to 7, **characterised in that** the chemical composition comprises, the content being expressed by weight:

$$0.30 < Si \leq 0.5\%.$$

9. A manufacturing method according to any one of claims 1 to 8, **characterised in that** the chemical composition comprises, the content being expressed by weight:

$$0.005 < Al < 0.030\%.$$

10. A method of manufacturing a cold-rolled and annealed sheet according to any one of claims 1 to 9, comprising the following successive steps: - a semi-finished product is supplied, the chemical composition of which comprises, the contents being expressed by weight:

$$0.09 < C \leq 0.11\%$$

$$2.6 \leq Mn < 2.8\%$$

$$0.20 < Si \leq 0.55\%$$

$$0.25 \leq Cr < 0.5\%$$

$$0.025 < Ti < 0.040\%$$

$$0.0015 \leq B \leq 0.0025\%$$

$$0.005 \leq Al \leq 0.18\%$$

$$0.08 \leq Mo \leq 0.15\%$$

$$0.020 \leq Nb < 0.040\%$$

$$0.002 < N < 0.007\%$$

$$0.0005\% \leq S < 0.005\%$$

$$0.001\% \leq P < 0.020\%,$$

$$Ca \leq 0.003\%$$

the remainder consisting of iron and unavoidable impurities from the manufacturing process, then

- said semi-finished product is heated to a temperature $T_r$ greater than or equal to 1250°C, then
- said semi-finished product is hot-rolled, the end-rolling temperature being higher than the temperature Ar3 at which the austenite begins to transform on cooling, to obtain a hot-rolled sheet, and then
- said hot-rolled sheet is cooled at a rate greater than 30°C/s to prevent the formation of ferrite and pearlite, and then
- the said hot-rolled sheet is coiled at a temperature of between 580° and 500°C, then
- the said hot-rolled sheet is cold-rolled to obtain a cold-rolled sheet, then
- the said cold-rolled sheet is reheated to between 600°C and Ac1, Ac1 designating the temperature at which austenitic transformation begins on heating, at a reheating rate of between 1 and 20°C/s, and then
- the said cold-rolled sheet is heated to a temperature Tm of between 780°C and (Ac3-25°C), and the said cold-rolled sheet is maintained at the said temperature Tm for a time Dm of between 30 and 150 seconds, it being understood that Ac3 designates the temperature at which the austenitic transformation ends on heating, then - the sheet is cooled at a speed VR1 of between 10 and 150°C/s to a temperature Te of between 400 and 490°C, then
- the sheet is held at the temperature Te for a time De of between 5 and 150 seconds, then
- the sheet is coated by continuous immersion in a bath of zinc or zinc alloy at a temperature TZn of between 450°C and 480°C, the said temperatures Te and TZn being such that $0 < (Te-TZn) \leq 10°C$, so as to obtain a coated sheet, then
- the said coated sheet is optionally heated to a temperature TG of between 490°C and 550°C for a time tG of between 10 s and 40 s.

11. Use of a steel sheet according to any one of claims 1 to 9, or manufactured by a process according to claim 10, for the manufacture of structural or safety parts for motor vehicles.

Figure 1

Figure 2

20 nm

Figure 3

50 nm

Figure 4

**RÉFÉRENCES CITÉES DANS LA DESCRIPTION**

**Documents brevets cités dans la description**

- US 20120312433 A1
- US 2012132327 A1
- US 20130209833 A1
- US 20110048589 A1
- US 201101683000 A1
- WO 2013144376 A1
- EP 2426230 A
- EP 2578718 A
- EP 2123786 A

**Littérature non-brevet citée dans la description**

- Darstellung der Umwandlungen für technische Anwendungen und Möglichkeiten ihrer Beeinflussung. **H.P. HOUGARDY**. Werkstoffkunde Stahl. Verlag Stahleisen, 1984, vol. 1, 198-231